# EUROPEAN PATENT SPECIFICATION

(11) **EP 2 206 810 B1**
(45) Date of publication and mention of the grant of the patent: **07.11.2012**
(21) Application number: 10161425.3
(22) Date of filing: 30.04.2009
(51) Int. Cl.: C30B 15/10, C30B 35/00

(54) **Crucible holding member and method for producing the same**
Tiegelhalterungselement und Herstellungsverfahren dafür
Élément support de creuset et son procédé de fabrication

(30) Priority: 01.05.2008 JP 2008119948
(43) Date of publication of application: 14.07.2010
(62) Divisional of application: 09006010.4
(73) Proprietor: Ibiden Co., Ltd., Ogaki-shi, Gifu 503-8604 (JP)
(72) Inventor: Kato, Hideki, Ogaki, Gifu (JP); Shikano, Haruhide, Ogaki, Gifu (JP); Yasuda, Masahiro, Ogaki, Gifu (JP)
(74) Representative: HOFFMANN EITLE

(56) References cited:
- EP-A- 0 839 941
- WO-A-02/072926
- WO-A-2006/107769
- DE-A1- 3 835 646
- DE-A1- 4 007 053
- JP-A- 11 255 587
- US-A- 6 136 094
- US-A1- 2002 088 390
- US-A1- 2002 170 492
- US-B1- 6 334 898

## Description

### BACKGROUND OF THE INVENTION

### Field of the Invention

The present invention relates to a crucible holding member for holding a crucible for containing a high-tempsrsture melt such as metal, glass or silicon, and particularly to a crucible holding member for holding a crucible used in a silicon single crystal pulling.

### Description of the Related Art

A carbon material has heretofore been widely used in a silicon single crystal pulling apparatus, for the reasons that the carbon material has high heat resistance and high thermal shock properties, and that the carbon material hardly contaminates silicon. In particular, an isotropic graphite material is hard to react with a reactive gas such as SiO generated in the apparatus due to its high density, and the reaction rate of the isotropic graphite material with SiO₂ as a material for a quartz crucible for containing a silicon melt is small. Accordingly, the isotropic graphite material has been used as a graphite crucible for holding the periphery of the quartz crucible.

In recent years, an increase in diameter of a silicon wafer has progressed in order to increase yield and improve productivity, and a 300-mm wafer has been becoming mainstream. The development of a wafer further increased in diameter exceeding 400 mm has also been advanced. With this increase in diameter of the silicon wafer, the size of the silicon single crystal pulling apparatus becomes large, so that the weight of the graphite crucible used in the pulling apparatus becomes extremely heavy, resulting in the difficulty of handling such as setting of the graphite crucible to the apparatus.

Further, a production process of the isotropic graphite material requires a press process under hydrostatic pressure, and requires a Cold Isostatic Press (CIP) apparatus having a size of about 1.5 times the diameter of the graphite product. The diameter of the conventional CIP apparatus is not enough for the isotropic graphite material as a large-size graphite crucible, so that a larger apparatus becomes necessary.

As a technique for producing the large-size graphite crucible without using the CIP apparatus, there has been proposed a technique including forming carbon fibers into a crucible form by a filament winding process, impregnating it with a resin or pitch as a matrix, and burning it to produce a crucible made of a carbon/carbon fiber composite, hereinafter referred to as a C/C composite (for example, see JP-A-10-152391 or JP-A-11-60373), and a technique including adhering carbon fiber cloth to a forming die, performing moulding and curing to obtain a carbon fiber-reinforced plastic, and then, impregnating and burning it to produce a crucible made of a C/C composite (for example, see JP-A-10-245275), or the like.

Further, as a method for forming a conventional graphite crucible made of an isotropic graphite material by using a small CIP apparatus, there has also been proposed a method of separately forming a graphite crucible divided into three or more pieces by CIP (for example, see JP-A-11-147199).

As described above, a larger CIP apparatus is required for the large-size graphite crucible using the isotropic graphite material, and it is necessary to provide excess thickness to a formed article at the time of the above-mentioned CIP forming as anticipation of deformation because the isotropic graphite deforms in a burning and graphitization steps, which causes the occurrence of material loss and the like.

Further, in a crucible holding member comprising a C/C composite, carbon fibers are used in large amounts, so that it is very expensive. Accordingly, an effect of decreasing production cost of wafers has not been sufficiently obtained even when the diameter of a silicon ingot is made large.

Further, the method of separately CIP forming the graphite crucible divided into three or more pieces has a problem that the difference from one another in the coefficient of thermal expansion or thermal conductivity causes the occurrence of a step at a divided portion of the crucible or the occurence of the difference in temperature for each divided piece of the crucible, at the time of heating to a temperature at which silicon is pulled up, resulting in difficulty of obtaining a high quality silicon ingot. Also in the production of the graphite material, the individual divided pieces are difficult to pack at the time of burning or graphitization, because the divided pieces have an unsymmetrical shape, or it is difficult to maintain the balance at the time of assembling and pulling up.

Further, an increase in the number of divided pieces of the crucible results in a decrease in the size of divided pieces, and when the crucible is cracked at the time of pulling up a silicon single crystal, the divided pieces are separated into a plurality of pieces. If the resulting fragments fall down in the pulling-up apparatus, they are entrapped between a heater and the crucible to make the crucible unrotatable, the heater is mechanically destroyed, or heating stops by an electrical short. Associated therewith, also on the quartz crucible side, the holding member is lost and deformed to lower a liquid level, thereby causing a fear of inducing crystal defects in silicon pulled up.

Further, when the silicon melt coagulates due to a problem such as a power failure immediately after the pulling-up is initiated, silicon has the property of expanding (a volume expansion of about 9.6%) with coagulation. Accordingly, this acts as the function of enlarging the quartz crucible and the graphite crucible. In the case of the apparatus for pulling up a small-diameter single crystal ingot, even when such a problem occurs to lead to cracking of the crucible, cooling is performed for a short period of time, and moreover, the amount of non-coagulated silicon which flows out is also small. Accordingly, it does not become a serious problem. However, in the case of the apparatus for pulling up a large-diameter single crystal ingot, when such a problem occurs, it takes time for cooling, and there has been a fear that a large amount of the silicon melt flows out in the apparatus.

Additionally, JP-A-1-183490 describes a technique of winding carbon fibers around at least a stress concentration zone on an outer wall portion of a graphite crucible for pulling up a single crystal, and adhering between the carbon fibers and the graphite crucible. However, the resistance force against cracks of the graphite crucible is increased by adhering to the carbon fibers wound ground, so that when the expansion force acts in a circumferential direction, as described above, there has been a fear that the binding force becomes a counterforce to result in the significant occurrence of deformation or cracks in the crucible itself.

DE 40 07 053 A1, WO 2006/107 769 US 2002/17092, US 5966794, and US 6,334,898 B1 are useful in understanding the background to the present invention.

### SUMMARY OF THE INVENTION

According to the present invention there is provided a crucible holding member as set out in Claim 1 below.

### BRIEF DESCRIPTION OF THE DRAWINGS

The above and other aspects of the present invention will become more apparent and more readily appreciated from the following description of exemplary embodiments of the present invention taken in conjunction with the attached drawings, in which:
Figs. 1A and 1B are schematic constitutional views showing a crucible holding member according to the invention as a side view and a plan view, respectively;
Figs. 2A and 2B are schematic constitutional views showing a modified embodiment in which an external fitting member is fitted by a tapered face as a side view and a cross-sectional view, respectively;
Fig. 3 is a side view showing a modified embodiment in which a protrusion of a mesh body from an outer surface of a quartz crucible supporting portion is restrained;
Fig. 4 is an enlarged front view showing a main part of a mesh body;
Fig. 5 is a flow chart showing a procedure of a production method of a crucible holding member;
Figs. 6A to 6D are schematic views showing a procedure of a production method of a quartz crucible supporting portion;
Fig. 7 is a flow chart showing a procedure of a production method of an external fitting member
Fig. 8 is a cross-sectional view showing a silicon single crystal pulling-up apparatus using the crucible holding member according to an embodiment of the present invention;
Fig. 9 is an enlarged front view showing a main part of an example of modification of a weave structure having no longitudinal strands
Fig. 10 is an enlarged front view showing a main part of an example of modification of a weave structure having a plurality of diagonal strands.

### DETAILED DESCRIPTION

The present disclosure has been made in view of the above-mentioned problems, and an object of the present disclosure is to provide a crucible holding member which can be easily produced even with a small-size CIP apparatus, which is stable in shape even when strong tension acts in the circumferential direction, and which is usable in a large-size single crystal pulling-up apparatus which can be operated even after a crack occurs at the time of pulling up.
(1) According to an aspect of the present disclosure, there is provided a crucible holding member comprising: a crucible supporting portion comprising a plurality of divided graphite pieces longitudinally divided in parallel to an axis line and radially arranged; and an external fitting member made of a C/C composite, which is circularly formed and fitted on a body portion of the crucible supporting porion to bind the divided graphite pieces in a circumferential direction.
   According to this crucible holding member, the crucible supporting portion comprises the plurality of divided graphite pieces divided in the circumferential direction, so that individual divided pieces can be formed small in size, even in the case of the large-size crucible.
(2) In the crucible holding member of (1), the external fitting member may be formed by a mesh body comprising a plurality of strands of carbon fibers woven diagonally to the axis line, and a matrix is filled in the interstices between the carbon fibers of the mesh body.
   The external fitting member is formed by the mesh body in which the strands are woven diagonally, so that even when strong tension acts in the circumferential direction, the diagonally woven strands can follow up the expansion. Even when the divided piece is cracked, the crack does not spread to the whole crucible support portion. Moreover, the divided pieces are surrounded by the external fitting member, so that dropping out thereof is prevented. Further, the external fitting member is detached, and the damaged divided piece can be replaced by a new divided piece, thereby becoming possible to continuously use the crucible holding member.
(3) In the crucible holding member of (2), the mesh body may comprise: a plurality of first strands provided in a first direction inclined at a first angle with respect to the axis line; and a plurality of second strands provided in a second direction inclined at second angle same as the first angle with respect to the axis line, the first direction being opposite to the second direction with respect to the axis line.
   According to this crucible holding member, rigidity in the circumferential direction is low, so that even when such force that expands in the circumferential direction acts on the crucible holding member, the mesh body can be enlarged in the circumferential direction by distortion of rhomboid-shaped lattices formed by the first strands and the second strand, thereby allowing the crucible supporting portion comprising the plurality of divided pieces to expand in the circumferential direction.
(4) In the crucible holding member of (2) or (3), the mesh body may further comprise a plurality of longitudinal strands along the axis line.
   According to this crucible holding member, the load of the crucible acting in a vertical direction corresponds with an extending direction of the longitudinal strands, so that the strength in the vertical direction of the mesh body increases.
(5) In the crucible holding member of any one of (2) to (4), the mesh body may be free from a strand provided in parallel to a circumferential direction in a plane perpendicular to the axis line.
   According to this crucible holding member, even when a force acts so as to expand in the circumferential direction, stress is not concentrated to some of the strands, because there is no strand present in the circumferential direction, resulting in no occurrence of breakage of the strands. Further, the mesh body becomes easy to expand in the circumferential direction (that is, no binding force is caused by that the mesh body is a rigid body in the circumferential direction), which improves expandability of the crucible supporting portion comprising the plurality of divided pieces.
(6) The crucible holding member of any one of (1) to (5), may further comprise a protrusion which is provided on the body portion of the crucible supporting portion, and which regulates dropping out of the external fitting member.
   According to this crucible holding member, the external fitting member is carried on the protrusion provided on the body portion, and always surely held without dropping out, not depending on fluctuations in a fitting state (fluctuations in fastening force) which relatively varies with changes in temperature.
(7) In the crucible holding member of any one of (1) to (6), the external fitting member and the crucible supporting portion may be fitted to each other by respective tapered faces thereof, a diameter of which becomes larger toward a bottom portion of the crucible supporting portion.
   According to this crucible holding member, even in a fitting state which expands or contracts with changes in temperatures, the external fitting member always moves toward a direction where the body portion is fastened, thereby being able to prevent dropping out and being able to continue to maintain the fitting state where looseness does not occur.
(8) In the crucible holding member of any one of (1) to (7), lower ends of the plurality of divided pieces arranged radially may be bound while surrounding a cylindrical space around the axis line. The crucible holding member may further comprise a plate provided with a cylindrical body protruding from an upper surface thereof. The cylindrical body may be fitted in the cylindrical space surrounded by the lower ends of the plurality of divided pieces.
   According to this crucible holding member, stable assembling of the divided pieces becomes possible. In order to increase heating efficiency from the bottom portion, the crucible has a structure of holding it at a center of the bottom portion and exposing a periphery thereof. Accordingly, the gravity center positions of the individual divided pieces depart from the axis line with an increase in the division number of the crucible, resulting in lack of stability and failure to be self-sustainable as a single body. According to this constitution, the lower ends of the divided pieces are brought into contact with the cylindrical body of the bedplate, thereby making it easy to carry out positioning.
(9) In the crucible holding member of any one of (1) to (8), a carbonaceous or graphite sheet may be spread on an inner surface of the crucible supporting portion at at least a portion at which adjacent divided graphite pieces are connected.
(10) A method for producing the crucible holding member according to any one of (1) to (9), comprises cutting out each of the divided pieces from a single isotropic graphite block in the same cutting direction.

According to this method, the difference from one another in the coefficient of thermal Expansion or thermal conductivity in the respective divided pieces does not occur, resulting in no occurrence of a step between the divided pieces or no occurrence of the difference in temperature.

According to the above-described holding member, the external fitting member circularly formed is fitted on the body portion of the crucible supporting portion to bind the plurality of divided pieces in the circumferential direction, and the external fitting member comprising the C/C composite. Accordingly, the individual divided pieces can be formed small in size, even in the case of the large-sized crucible, so that the crucible holding member can be easily produced with the small-sized CIP apparatus. Further, even when the divided piece is cracked at the time of operation of the silicon single crystal pulling-up apparatus, the crack does not spread to the whole crucible. Moreover, the divided pieces are surrounded by the external fitting member to be prevented from dropping out, so that the silicon single crystal pulling-up operation can be safely performed.

Embodiments of crucible holding members according to the invention will be described with reference to the drawings.

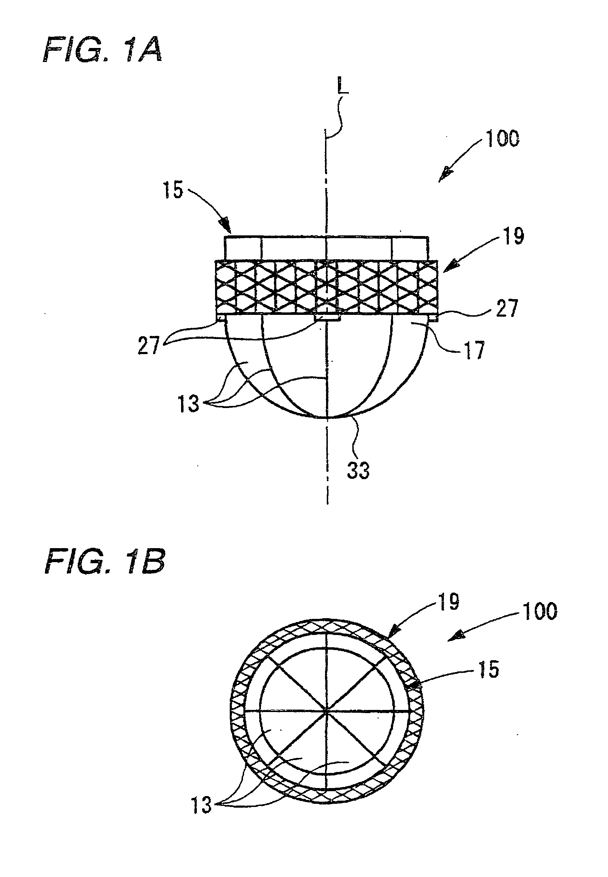

Figs. 1A and 1B are schematic constitutional views showing a crucible holding member according to an embodiment of the invention as a side view and a plan view, respectively.

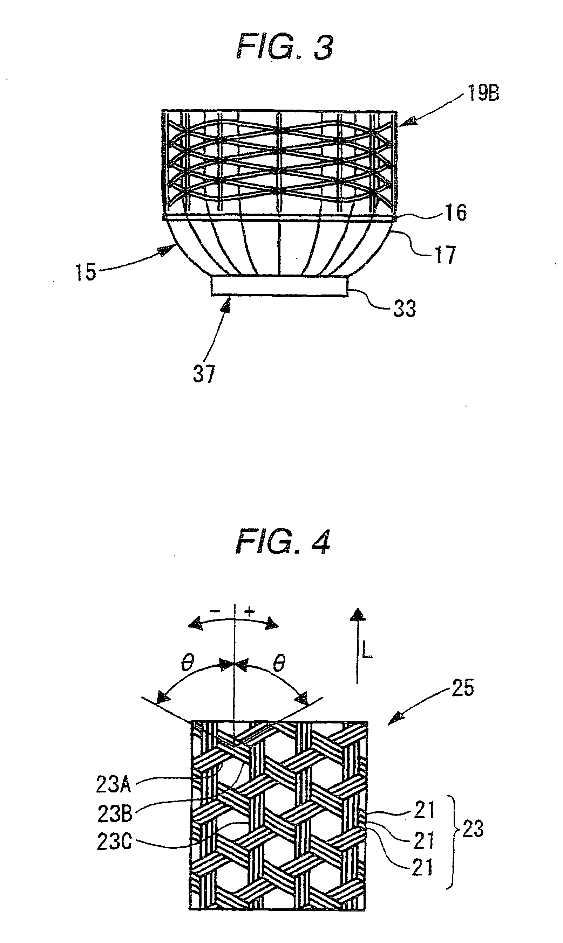

According to this embodiment, the crucible holding member 100 comprises a quartz crucible supporting portion 1 comprising a plurality (8 pieces in the example shown in Fig. 1) of divided graphite pieces 13 longitudinally divided in parallel to an axis line L and radially arranged, and an external fitting member 19 circularly formed and fitted on a body portion 17 of the quartz crucible supporting portion 15 to bind the quartz crucible supporting portion 15 (the plurality of divided graphite pieces 13) in a circumferential direction. The external fitting member 19 comprises a C/C composite. Although the constitution of the C/C composite is not particularly limited there can be suitably utilized, for example, a C/C composite formed by a mesh body 25 in which strands 23 of carbon fibers 21 (see Fig. 4) are woven diagonally to the axis line L and the interstices between the carbon fibers 21 1 of the mesh body 25 is filled with a matrix.

It is required in all embodiments of the invention that the divided pieces 13 are not individually produced, but are prepared by cutting out from a single isotropic graphite block in the same cutting direction. This is because occurrence of a step caused by the difference in thermal expansion or occurrence of heating unevenness caused by the difference in thermal conductivity becomes rare at the time of use. In the quartz crucible supporting portion 15, even when a divided piece 13 is cracked by deterioration, no crack extends until the crucible is broken, because the external fitting member 19 has a function for retaining the shape of the quartz crucible supporting portion 15. In particular if old and new divided pieces 13 are arranged at a cycle of several pieces so as not to lose an overall balance, deterioration of the quartz crucible supporting portion 15 does not proceed as a whole. Accordingly, changes in temperature characteristics between before and after exchange of the crucible can be minimized so that stable pulling-up operation can be performed. Further, old divided pieces which are easily broken and new divided pieces which are hard to be broken are mixedly arranged, so that even when an old divided piece is cracked, it is rare to proceed to large breakage

It is advantageous that the external fitting member 19 has elasticity in the circumferential direction. Since the coefficient of thermal expansion of the C/C composite is smaller than that of the isotropic graphite material, large force (fastening force) is applied to the quartz crucible supporting portion 15 with an increased in temperature. It is advantageous to provide a space between the external fatting member 19 and the quartz crucible supporting portion 15 so as to be easily assembled. Further, it is advantageous to provide a drop-preventing means so that the external fitting member does not drop from the quartz crucible supporting portion 15. As the drop-preventing means, there can be used a flange 27 which is provided on the body portion 17 of the quartz crucible supporting portion 15 to protrude therefrom and regulates dropping out of the external fitting member 19. In this case, the external fitting member 19 is held on the flange 27 thereby, irrespective of fluctuations in a fitting state (fluctuations in fastening force) which relatively varies with changes in temperature, so that the external fitting member 19 is always surely held without dropping out.

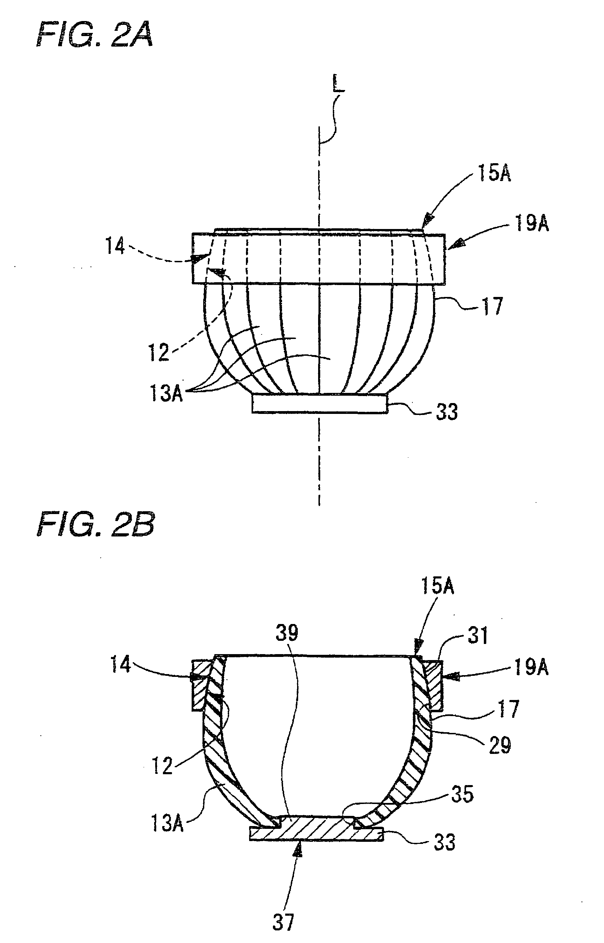

Figs. 2A and 2B are schematic constitutional views showing a modified embodiment in which an external fitting member is fitted by a tapered face as a side view and a cross-sectional view, respectively.

The drop-preventing means may be tapered faces 29 and 31 provided on an inner circumferential surface 12 of an external fitting member 19A and an outer circumferential surface 14 of a quartz crucible holding portion 15A. Each of the tapered faces 29 and 31 has a diameter which becomes larger toward a bottom portion 33 of the quartz crucible supporting portion 15A. The tapered faces 29 and 31 are fitted with each other, so that even when a fitting state changes (expands and contracts) with changes in temperatures, the external fitting member always moves toward a direction in which the body portion is fastened, thereby being able to prevent dropping out and being able to maintain the fitting state without looseness.

Further, the external fitting member 19 may be fixed from the outside thereof to the quartz crucible supporting portion 15 by using a fixture such a bolt made of a carbon material or a C/C composite, or may be suspended thereon. In particular, when the external fitting member 19 has low elasticity, and is hard to follow up deformation of the quartz crucible supporting portion 15 made of graphite, it is advantageous that the fitting faces of the quartz crucible holding portion 15A and the external fitting member 19A have the above-mentioned tapered faces 29 and 31 expanding toward a bottom. This makes it possible to fasten always the quartz crucible holding portion 15A without looseness even when silicification reaction occurs with repetition of use.

As shown in Fig. 2, the quartz crucible holding portion 15A is not necessarily divided from an axis line L, and an axis line portion may be provided as another member and divided pieces 13A may be arranged around the other member. By arranging the divided pieces in such a manner, the individual divided pieces 13A can be reduced in size. As a result, the large crucible can be provided as a whole.

For example, as shown in Fig. 2, the quartz crucible holding portion 15A can have a structure that lower ends of the plurality (16 pieces in the example shown in Fig. 2) of divided pieces 13A arranged radially are bound while surrounding a cylindrical space 35 around the axis line L, and a cylindrical body 39 protruding from an upper surface of a bedplate 37 is fitted in the cylindrical space 35. Accordingly, stable assembling of the divided pieces 13A becomes possible. The gravity center positions of the individual divided pieces 13A depart from the axis line L with an increase in the division number of the crucible, resulting in lack of stability and failure to be self-sustainable as a single body. According to this constitution, the lower ends of the divided pieces 13A are brought into contact with the cylindrical body 39 of the bedplate 37, thereby making it easy to carry out positioning of the divided pieces 13A. Further, in a case where the bottom portion 33 and the body portion 17 are constituted by graphite members different from each other, the shape of the individual divided pieces 13A becomes closer to a rectangular parallelepiped, which causes an improvement in the yield of the material.

Fig. 3 is a side view showing a modified embodiment in which a protrusion of a mesh body from an outer surface of a quartz crucible supporting portion is restrained.

As shown in Fig. 4, a mesh body 25 forming an external fitting member 19A can efficiently transmit radiation heat from a heater to a quartz crucible supporting portion 15 by enlarging opening portions. In Fig. 3, the reference numeral 16 designates a drop-preventing means fitted to a body portion 17 for preventing dropping out of an external fitting member 19B which is thin in thickness.

Fig. 4 is an enlarged front view showing a main part of a mesh body.

A mesh body 25 is formed by a triaxial weave, using ribbon-like strands 23 each obtained by bundling a plurality of carbon fibers 21 as plaited threads. That is, the mesh body 25 has a triaxial weave structure comprising first strands 23A provided in a first direction inclined at a angle of inclination of +θ (0<θ<90 degree) with respect to an axis line L of the mesh body 25, second strands 23B provided in a second direction inclined at an angle of inclination of -θ, and longitudinal strands 23C provided substantially along the axis line L.

The mesh body 25 can secure high strength because the first strands 23A and the second strands 23B are braided with each other in a braid shape, and can firmly hold a quartz crucible supporting portion 15. Moreover, the first strands 23A and the second strands 23B are aligned diagonally to the axis line L of the mesh body 25, and not aligned in a direction perpendicular to the central axis (that is, in the circumferential direction of the mesh body 25), so that there is obtained a structure in which the rigidity in the circumferential direction is low. For this reason, even when such force that expands in the circumferential direction acts on the quartz crucible supporting portion 15 due to some cause, rhomboid-shaped lattices formed by the first strands 23A and the second strands 23B are distorted, whereby the mesh body 25 can be enlarged in the circumferential direction to allow the quartz crucible supporting portion 15 comprising the plurality of divided pieces 13 to expand in the circumferential direction,

Further, in the mesh body 25, the angle of inclination θ of the first strands 23A and the second strands 23B with respect to the axis line L can be appropriately changed, depending on the rigidity required for each part of the crucible holding member 100. The rigidity in the circumferential direction of the mesh body 25 can be adjusted by changing the angle of inclination θ, so that the rigidity in the circumferential direction can be changed depending on the use thereof or according to each part of the mesh body 25.

The mesh body 25 has the longitudinal strands 23C aligned in the direction parallel to (along) the axis line L (woven in a same plane as the axis line L). Since the mesh body has the longitudinal strands 23C, external force acting in a vertical direction agrees with an extending direction of the longitudinal strands 23C to increase strength in the vertical direction of the mesh body 25.

The strands 23 are each formed by bundling about hundreds to tens of thousands of carbon fibers 21. As the carbon fibers 21 constituting the strands 23, there can be used pitch-based carbon fibers, PAN-based carbon fibers or the like. The carbon fibers 21 constituting the first strands 23A, the second strands 23B and the longitudinal strands 23C may be the same material or different materials.

The shape of the strands 23 may be a rod form or the like, as well as a ribbon form. Further, if strands subjected to sizing treatment by impregnating them with an epoxy resin or the like are used as the strands 23, appropriate elasticity is obtained. Accordingly, even when weaving is performed manually, the strands are easily woven in an equal cycle.

A matrix precursor for coating the mesh body 25 may be any, as long as it can form a carbonaceous or graphitic matrix by burning. As the matrix precursor carbonized or graphitized by burning, there can be used pitch obtained from petroleum, coal or the like, as well as a thermosetting resin having a high carbonization yield such as a COPNA resin, a phenol resin, a furan resin or a polyamide resin. Further, the matrix can also be formed by Chemical Vapor Impregnation (CVI) of pyrolytic carbon, SiC or the like.

As described above, in the crucible holding member 100, the quartz crucible supporting portion 15 is constituted by the plurality of divided pieces 13 divided in the circumferential direction. Accordingly, individual divided pieces can be formed small in size even in the case of the large-sized crucible. In the case where the external fitting member 19 is formed by the body 25 in which the strands 23 are woven diagonally, even when strong tension acts in the circumferential direction, the diagonally woven strands 23 can follow up the expansion. Even when the divided piece 13 is cracked, the crack docs not spread to the whole crucible holding member. Moreover, the divided pieces are surrounded by the external fitting member 19, so that dropping out thereof is prevented.

The external fitting member 19 is fastened at an operating temperature, even when it has been loosely fitted at room temperature, so that an assembling operation becomes easy. There can be provided the graphite crucible in which the external fitting member 19 is easily removable without being firmly fitted with the quartz crucible supporting portion 15. It becomes possible thereby to exchange the broken divided piece. Incidentally, in the external fitting member 19, stitches are advantageous to have opening portions. Radiation heat from the heater directly arrives at the quartz crucible supporting portion 15 by providing the opening portions, thereby being able to beat a silicon melt well.

Further, in the crucible holding member 100 longitudinally divided, a space is formed between divided faces by thermal expansion of the quartz crucible or silicification reaction on the inner face side of graphite. It has been known that at the time of operation, the radiation heat from the heater enters through such space between the divided faces to expose an edge portion on the inner side contacting the quartz crucible to high temperatures, resulting in rapid consumption thereof. When the number of divided pieces 13 increase, the number of places where such reaction occurs increasses. Accordingly, an easily exchangeable high-purity expanded graphite sheet or the like may be spread on the whole inner face of the quartz crucible supporting portion 15 or a portion at which adjacent divided pieces 13 are connected to prevent the silicification reaction or thickness decreasing reaction of the quartz crucible supporting portion 15.

As described above, according to the above-mentioned crucible holding member 100, the external fitting member 19 circularly formed is fitted on the body portion 17 of the quartz crucible supporting portion 15 to bind the plurality of divided pieces 13 in the circumferential direction, and the external fitting member 19 is constituted by the mesh body 25 in which strands 23 comprising carbon fibers 21 are woven diagonally. Accordingly, the individual divided pieces 13 can be formed small in size, even in the case of the large-sized crucible, so that the crucible holding member can be easily produced with the small-sized CIP apparatus. Further, even when strong tension acts in the circumferential direction, the diagonally woven strands 23 follows up the expansion to be stable in shape. Even when the divided piece 13 is cracked at the time of operation of the silicon single crystal pulling-up apparatus, the crack does not spread to the whole crucible supporting portion. Moreover, the divided pieces are surrounded by the external fitting member 19 to be prevented from dropping out, so that the silicon single crystal pulling-up operation can be safely performed.

One example of a method for producing the crucible holding member will be described below with reference to Figs, 5 and 6.

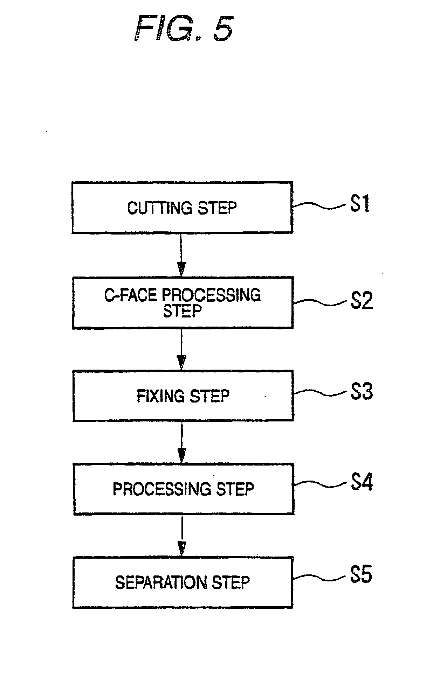

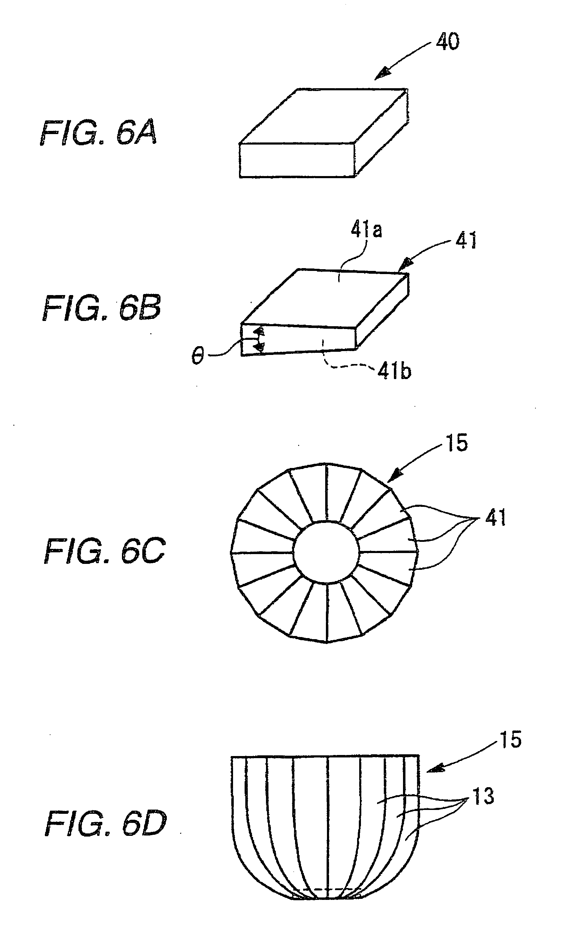

Fig. 5 is a flow chart showing a procedure of a production method of the crucible holding member, and Figs. 6A to 6D are schematic views showing a procedure of a production method of the quartz crucible supporting portion.

The quartz crucible supporting portion 15 has a rotationally-symmetric shape, so that for forming the individual divided pieces 13, it is only necessary to repeatedly prepare same shape pieces, and a production method thereof is easy.

One example of the production method thereof is mentioned below, but the method for producing a crucible holding member according to an embodiment of the invention is not limited thereto.

The crucible holding member 100 according to this embodiment can be produced mainly by the following five steps: namely, a cutting step S1, a C-face processing step S2, a fixing step S3, a processing step S4 and a separation step S5.

### A) Cutting Step to obtain Divided Pieces S 1

First, a hexahedron 40 shown in Fig. 6A is obtained by cutting into a size of the individual divided pieces 13. As for a cutting direction at this time, it is required in all embodiments of the invention to be cut in a same cutting direction for each divided pieces 13 while considering anisotropy of material. Further, in order to restrain fluctuations of variations of the material and make uniform the coefficient of thermal expansion of the individual divided pieces, it is required in all embodiments of the invention to be cut out from a single isotropic graphite material in a same cutting direction.

In general, in CIP formation from an orientation direction of crystal grains, the coefficient of thermal expansion becomes highest in an up-and-down direction in the formation, and the coefficient of thermal expansion becomes low in horizontal two directions in the formation, compared to that in the up-and-down direction. In the case where the cutting direction is inconsistent for the divided pieces, when the crucible holding member 100 is heated, it deforms nonuniformly by thermal expansion to cause deformation of the shape of the whole crucible holding member or the occurrence of large spaces.

### B) C-Face Processing of Divided Pieces S2

As shown in Fig. 6B, an angle between plate faces 41a and 41b is adjusted according to a division number of divided pieces 13. For example, when evenly divided, the angle θ between the plate faces 41a and 41b is determined by the division number n to become θ =360/n (°). Incidentally, a plurality of shapes of the divided pieces 13 maybe included while being not evenly divided.

C-Face processing may employ any method. As a first example, a C-face processing method includes fixing the above-mentioned plate 40 onto a jig inclined at an angle of half (θ/2) the angle θ between the above-mentioned both plate faces 41a and 41b, processing it with a flat-surface grinding machine or a whetstone, then, fixing the opposite side face of the plate 40 onto the jig inclined at an angle of θ, and processing it with a flat-surface grinding machine or a whetstone. According to such a method, there is obtained a C-fact-processed article in which the both faces are symmetrical in shape.

As a second example, a C-face processing method includes fixing the above-mentioned plate 40 onto a jig inclined at an angle corresponds to the angle (θ) between the above-mentioned both plate faces 41a and 41b, and processing it with a flat-surface grinding machine or a whetstone. According to such a method, C-face processing can be performed in one step.

As a third example, a C-facc processing method includes, after the C-face processing of the second example is performed, performing processing so as to adjust the angle of a face closest to the axis Line L of the crucible holding member. According to this method, the area to be processed is small, so that a C-face-processed article obtained by the first processing method is easily obtained.

C) Fixing Step of Divided Pieces S3

As shown in Fig. 6C, the C-face-processed articles 41 obtained in step S2 are fixed so as to form a crucible share. A faxing method at this time may be any as long as it is a method of using a means easily removable after processing. There may be used a method of fixing the articles with an adhesive such as an α-cyanoacrylate (an instant adhesive) which is easily removable by heating after processing, a method of clamping upper and lower faces which have processed already, or the like.

At this fixing step, it is necessary to precisely match an axis line L in turning is performed later to the axis line L of the quartz crucible supporting portion 15 combined. If they do not match, the shape of the crucible holding member becomes distorted. In particular, when the divided pieces of the quartz crucible supporting portion 15 do not contain the axis line L of the crucible holding member, it is possible to precisely match the axis line by fixing with butting against a cylinder-shaped jig.

D) Processing Step of Quartz Crucible Supporting Portico S4

As shown in Fig. 6D, the quartz crucible supporting portion 15 fixed in step S3 is processed to a desired shape. The crucible holding member 100 according to this embodiment is used in the silicon single crystal pulling-up apparatus, and has a rotationally-symmetric body. Accordingly, it can be processed mainly by using a turning machine. When a shape of the crucible holding member is not rotationally symmetric, it is possible to perform processing by using a machining center or the like.

E) Separation Step of Quartz Crucible Supporting Portion S5

The quartz crucible supporting portion 15 processed in step S4 is separated into the individual divided pieces 13. When the C-face-processed articles are fixed with the adhesive such as the α-cyanoacrylate in step S3, the adhesive can be depolymerized in short time. As a heating method, there can be used a method of placing the whole in a furnace, a method of burning adhered portions with a propane gas burner, or the like. The oxidation starting temperature of graphite in the air is 400°C, and when heated to about 200 to 300°C, the α-cyanoacrylate is depolymerized until then to be able to easily separate the divided pieces 13.

Then, there will be described one example of a production method of the external fitting member.

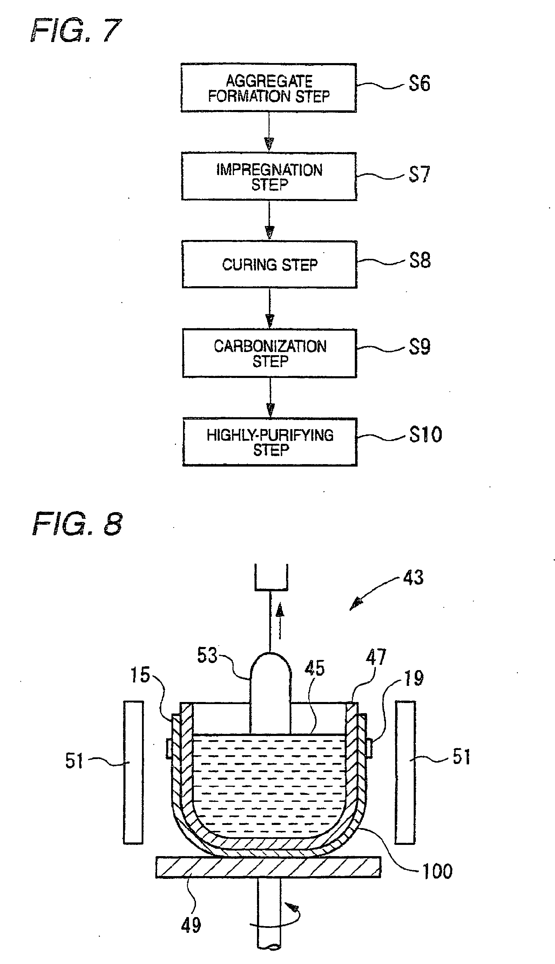

Fig. 7 is a flow chart showing a procedure of a production method of the external fitting member.

The external fitting member 19 can be produced mainly by the following five steps: namely, an aggregate formation step S6, an impregnation step S7, a curing step S8, a carbonization step S9 and a highly-purifying step S10.

F) Aggregate Formation Step S6

The carbon fibers 21 are wound around a cylindrical or truncated cone-shaped die to form a shape of the external fitting member 19. As a winding method, the carbon fibers may be wound merely in a circumferential direction or as a carbon fiber cloth.

In particular, when it is desired to control elasticity in the circumferential direction, a triaxial weave comprising strands 23 aligned along a longitudinal direction and strands 23 spirally wound around in opposed directions may be used.

The external fitting member 19A formed by winding the carbon fibers around the truncated cone-shaped die can be brought into contact with the tapered face 31 expanding downward on the outer surface of the crucible (see Fig. 2). In addition to elasticity of the external fitting member 19A, the external fitting member 19A imparts fastening force by the action of gravity, thereby being able to always restrain expansion of the quartz crucible supporting portion 15A.

In the external fitting member 19, breakage of the fibers rarely occurs due to its elasticity, even when burned in the production stage as it is wound around the die different in the coefficient of thermal expansion, so that the external fitting member 19 can be easily produced.

G) Resin Impregnation Step S7

The die around which the carbon fibers are wound, which has been obtained in the above-mentioned step S6, is immersed in a resin to impregnate the carbon fibers with the resin. The resin used for impregnation is not particularly limited, and it may be any, as long as it can be carbonized by burning. It may be a synthetic resin such as a phenol resin, a furan resin, a polyimide resin, or divinylbenzene, pitch obtained from petroleum or coal, or the like. If vacuuming is performed before the impregnation, voids are not likely to remain in the strands. Accordingly, the homogeneous external fitting member 19 can be obtained. The impregnation may be performed either at normal pressure or under increased pressure. Further, if the carbon fibers are thin and wettability with the resin to be impregnated is poor, the impregnation under increased pressure is effective.

H) Curing Step S8

When a resin producing by-products in large amounts at the time curing (for example, a phenol resin or the like) is selected as the resin for impregnation, it is advantageous to perform the curing step in order to prevent foam formation. It may be important to slow down the increase rate of temperature around a temperature at which gelatoin reaction associated with the curing severly occurs (although it varies depending on the kind of resin, roughly about 100 to 150°C) in order to sufficiently vent a generated gas so as to make it possible to sufficiently diffuse a gas.

I) Carbonization Step S9

Organic substance contained in the external fitting member 19 impregnated with the resin, which has been obtained in step S8, is carbonized to obtain an external fitting member 19 mainly comprising carbon. Since contraction in size occurs in burning, it is advantageous that the die used in winding is removed before the carbonization step.

The treatment temperature in the carbonization step is preferably at least about 600°C (a temperature at which the discharge of the organic gas starts to subside), and more preferably 900°C (a temperature at which contraction in size and gas generation subside) or higher.

J) Highly-Purifying Step S10

The quartz crucible supporting portion 15 and the external fitting member 19 obtained by the above-mentioned methods, respectively, are highly purified to a purity level at which they can be used in a silicon single crystal pulling-up apparatus.

As a method for high purification, impurities are removed by heat treatment at high temperatures using a known halogen gas.

Then, as an example of use of the crucible holding member according to this embodiment, the crucible holding member applied to a silicon single crystal pulling-up apparatus will be described using Fig. 8.

Fig. 8 is a cross-sectional view showing a silicon single crystal pulling-up apparatus using the crucible holding member according to the embodiment.

The silicon single crystal pulling-up apparatus 43 is equipped with a quartz crucible 47 for containing a silicon melt 45 and the crucible holding member 100 for hooding an outer peripheral surface of the quartz crucible 47 in such a state as to surround it from the outside. These are placed on a support 49. A heater 51 is arranged aground the periphery of the crucible holding member 100, and an ingot 53 is gradually pulled up while heating the silicon melt 45 through the quartz crucible 47 and the crucible holding member 100 with the heater 51, thereby producing a silicon single crystal.

Even when force to expand in the circumferential direction is applied, the external fitting member 19 can follow up the expansion, so that the crucible holding member 100 used herein can prevent the occurrence of cracks, an outflow of the non-coagulated melt, and the like, thus being able to improve reliability.

In addition, a carbonaceous or graphitic sheet such as an expanded graphite sheet or a carbon fiber papermaking sheet may be allowed to intervene between the crucible holding member 100 and the quartz crucible 47. When such a carbonaceous or graphitic sheet is allowed to intervene, the quartz crucible 47 and the crucible holding member 100 do not directly contact with each other, so that the deterioration of the crucible holding member 100 caused by a reaction with the quartz crucible 47 is not likely to occur. Accordingly, there is a merit that the crucible holding member can be repeatedly used by exchanging only the carbonaceous or graphitic sheet.

In the above-mentioned example of use, there is shown the example in which the crucible holding member has been applied to the quartz crucible holding member of the silicon single crystal pulling-up apparatus. However, the use of the crucible holding member according to the embodiment of the invention is not limited thereto, and it can be applied to any use, as long as it is, for example, a member for holding a container for containing a melt of metal, glass, silicon or the like. In particular, when it is applied to a member for holding a container different therefrom in the coefficient of thermal expansion in the inside thereof, the above-mentioned advantages are obtained.

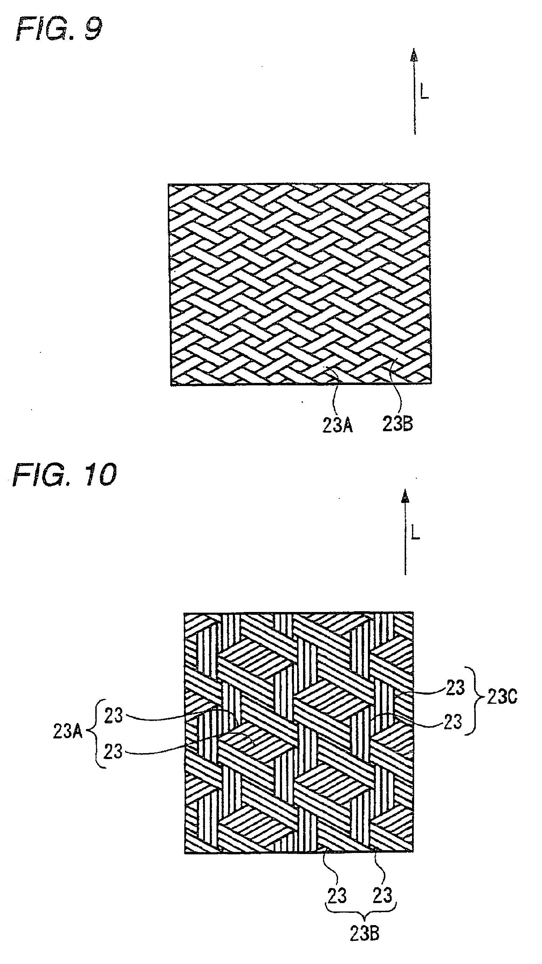

Fig. 9 is an enlarged front view showing a main part of an example of modification of a weave structure having no longitudinal strands, and Fig. 10 is an enlarged front view showing a main part of an example of modification of a weave structure having a plurality of diagonal strands.

In the above-mentioned embodiments, the mesh body 25 formed by the triaxial weave is shown. However, the mesh body 25 is not limited to one obtained by the triaxial weave, and may have a configuration having only strands 23A and 23B aligned diagonally to an axis line L, us shown in Fig. 9. That is, the mesh body has no strand in the circumferential direction in a plane perpendicular to the axis line L (in the lateral direction in Fig. 9). Stress is not concentrated to some of the strands thereby, even when such force as to expand in the circumferential direction acts, because no strand in the circumferential direction is present, resulting in no occurrence of breakage of the strands.

Further, as shown in Fig. 10, it may have a configuration in which two or more strands 23 and 23 are aligned diagonally.

[Examples]

Examples will be described below in which crucible holding members having the same structures as the above-mentioned embodiments were prepared and the presence or absence of dropping out of fragments at the time when divided pieces were cracked was checked.

<Example 1>

A crucible holding member was prepared by a quartz crucible supporting portion containing an axis line of a crucible and divided into 16 pieces, and an external fitting member comprising carbon fibers and a matrix of a carbide of a phenol resin impregnated between the carbon fibers. Contact faces of the quartz crucible supporting portion and the external fitting member were fitted to each other by tapered faces expanded toward bottom.

In the crucible holding member prepared, the external fixing member acted so as to always fasten the quartz crucible supporting portion by gravity, and the divided pieces did not open.

One divided piece of the quartz crucible supporting portion was cracked so as to be divided up and down into two parts approximately at a central portion. Then, a quartz crucible was placed in the crucible, and the whole crucible was placed on a crucible supporting table. At this time, the cracked divided piece did not drop out by the effect of the external fitting member, and the crucible holding member kept the shape of the crucible as a whole.

<example 2>

A crucible holding member was prepared by a quartz crucible supporting portion containing no axis line of a crucible and divided into 16 pieces, a mesh of a triaxial weave comprising strands aligned in a longitudinal direction and strands spirally wound around in opposed directions, and an external fitting member comprising carbon fibers and a matrix of a carbide of a phenol resin impregnated between the carbon fibers. The external fitting member was fitted outside on the quartz crucible supporting portion, and prevented from dropping out by a protrusion provided on a lower portion of an outer circumferential portion of the quartz crucible supporting portion.

The external fitting member had elasticity, so that it was fitted in a state where it was expanded toward the outer circumference. The fastening action always acted, and the divided pieces did not open.

Further, one divided piece of the quartz crucible supporting portion was cracked so as to be divided up and down into two parts approximately at a central portion. Then, a quartz crucible was placed in the crucible, and the whole crucible was placed on a crucible supporting table, At this time, the cracked divided piece did not drop out by the action of the external fitting member, and the crucible holding member kept the shape of the crucible as a whole.

### Further disclosure

The following numbered paragraphs relate to particular configurations conceptually related to the preceding disclosure.
1. A crucible holding member comprising:
   a crucible supporting portion comprising a plurality of divided graphite pieces longitudinally divided in parallel to an axis line and radially arranged; and
   an external fitting member made of a C/C composite, which is circularly formed and fitted on a body portion of the crucible supporting portion to bind the divided graphite pieces in a circumferential direction.
2. The crucible holding member according to paragraph 1,
   wherein the external fitting member is formed by a mesh body comprising a plurality of strands of carbon fibers woven diagonally to the axis line, and a matrix is filled in the interstices between the carbon fibers of the mesh body.
3. The crucible holding member according to paragraph 2,
   wherein the mesh body comprises:
   a plurality of first strands provided in a first direction inclined at a first angle with respect to the axis line; and
   a plurality of second strands provided in a second direction inclined at second angle same as the first angle with respect to the axis line, the first direction being opposite to the second direction with respect to the axis line.
4. The crucible holding member according to paragraph 2 or 3,
   wherein the mesh body further comprises a plurality of longitudinal strands along the axis line.
5. The crucible holding member according to any one of paragraphs 2 to 4,
   wherein the mesh body is free from a strand provided in parallel to a circumferential direction in a plane perpendicular to the axis line.
6. The crucible holding member according to any one of paragraph 1 to 5, further comprising a protrusion which is provided on the body portion of the crucible supporting portion, and which regulates dropping out of the external fitting member.
7. The crucible holding member according to any one of paragraphs 1 to 6,
   wherein the external fitting member and the crucible supporting portion are fitted to each other by respective tapered faces thereof, a diameter of which becomes larger toward a bottom portion of the crucible supporting portion.
8. The crucible holding member according to any one of paragraphs 1 to 7,
   wherein lower ends of the plurality of divided pieces arranged radially are bound while surrounding a cylindrical space around the axis line,
   the crucible holding member further comprising a plate provided with a cylindrical body protruding from an upper surface thereof,
   wherein the cylindrical body is fitted in the cylindrical space surrounded by the lower ends of the plurality of divided pieces.
9. The crucible holding member according to any one of paragraphs 1 to 8,
   wherein a carbonaceous or graphite sheet is spread on an inner surface of the crucible supporting portion at at least a portion at which adjacent divided graphite pieces are connected.
10. A method for producing the crucible holding member according to any one of paragraphs 1 to 9, the method comprising cutting out each of the divided pieces from a single isotropic graphite block in the same cutting direction.

## Claims

1. A crucible holding member (100) comprising:
a crucible supporting portion comprising a plurality of divided graphite pieces (13) longitudinally divided in parallel to an axis line and radially arranged; and
an external fitting member (19) made of a C/C composite, which is circularly formed and fitted on a body portion of the crucible supporting portion to bind the divided graphite pieces in a circumferential direction, wherein all of the divided pieces are formed by cutting a single isotropic graphite block in the same cutting direction.

2. The crucible holding member according to claim 1,
wherein the external fitting member is formed by a mesh body comprising a plurality of strands (23) of carbon fibers woven diagonally to the axis line (L), and a matrix is filled in the interstices between the carbon fibers of the mesh body.

3. The crucible holding member according to claim 2,
wherein the mesh body comprises:
a plurality of first strands (23A) provided in a first direction inclined at a first angle with respect to the axis line; and
a plurality of second strands (23B) provided in a second direction inclined at second angle same as the first angle with respect to the axis line, the first direction being opposite to the second direction with respect to the axis line.

4. The crucible holding member according to claim 2 or 3,
wherein the mesh body further comprises a plurality of longitudinal strands (23C) along the axis line.

5. The crucible holding member according to any one of claims 2 to 4,
wherein the mesh body is free from a strand provided in parallel to a circumferential direction in a plane perpendicular to the axis line.

6. The crucible holding member according to any one of claims 1 to 5, further comprising a protrusion (27) which is provided on the body portion of the crucible supporting portion, and which regulates dropping out of the external fitting member.

7. The crucible holding member according to any one of claims 1 to 5,
wherein the external fitting member and the crucible supporting portion are fitted to each other by respective tapered faces (29, 31) thereof, a diameter of which becomes larger toward a bottom portion of the crucible supporting portion.

8. The crucible holding member according to any one of claims 1 to 7,
wherein lower ends of the plurality of divided pieces arranged radially are bound while surrounding a cylindrical space (35) around the axis line (L),
the crucible holding member further comprising a plate (37) provided with a cylindrical body (39) protruding from an upper surface thereof,
wherein the cylindrical body is fitted in the cylindrical space surrounded by the lower ends of the plurality of divided pieces.

9. The crucible holding member according to any one of claims 1 to 8,
wherein a carbonaceous or graphite sheet is spread on an inner surface of the crucible supporting portion at at least a portion at which adjacent divided graphite pieces are connected.

## Patentansprüche

1. Tiegelhalteelement (100) mit:
einem Tiegellagerabschnitt mit mehreren zerteilten Graphitstücken (13), die längs parallel zu einer Achsenlinie zerteilt und radial angeordnet sind und
einem äußeren Einpasselement (19) aus einem C/C-Verbundwerkstoff, das kreisförmig ausgebildet ist und auf einen Körperabschnitt des Tiegellagerabschnitts eingepasst ist, um die zerteilten Graphitstücke umfänglich zu verbinden, wobei alle zerteilten Stücke durch Schneiden eines einzelnen isotropen Graphitblocks in derselben Schneidrichtung ausgebildet sind.

2. Tiegelhalteelement nach Anspruch 1, bei dem das äußere Einpasselement durch einen Maschenkörper mit mehreren Strängen (23) aus Kohlefasern, die diagonal zu der Achsenlinie (L) verwoben sind, ausgebildet ist und wobei eine Matrix in die Lücke zwischen den Kohlefasern des Maschenkörpers eingefüllt ist.

3. Tiegelhalteelement nach Anspruch 2,
bei dem der Maschenkörper aufweist:
mehrere erste Stränge (23A), die in einer ersten Richtung vorgesehen sind, die mit einem ersten Winkel bezüglich der Achsenlinie geneigt ist; und
mehrere zweite Stränge (23B), die in einer zweiten Richtung vorgesehen sind, die mit einem zweiten Winkel, der gleich dem ersten Winkel ist, bezüglich der Achsenlinie geneigt ist, wobei die erste Richtung entgegengesetzt zu der zweiten Richtung bezüglich der Achsenlinie ist.

4. Tiegelhalteelement nach Anspruch 2 oder 3,
bei dem der Maschenkörper ferner mehrere Längsstränge (23C) entlang der Achsenlinie aufweist.

5. Tiegelhalteelement nach einem der Ansprüche 2 bis 4,
bei dem der Maschenkörper frei von einem Strang ist, der parallel zu einer Umfangsrichtung in einer Ebene senkrecht zu der Achsenlinie vorgesehen ist.

6. Tiegelhalteelement nach einem der Ansprüche 1 bis 5, ferner mit einem Vorsprung (27), der auf dem Körperabschnitt des Tiegellagerabschnitts vorgesehen ist und der ein Herausfallen des äußeren Einpasselements reguliert.

7. Tiegelhalteelement nach einem der Ansprüche 1 bis 5,
bei dem das äußere Einpasselement und der Tiegellagerabschnitt aneinander durch jeweilige angefaste Flächen (29, 31) eingepasst sind, deren Durchmesser zu einem unteren Abschnitt des Tiegelhalteabschnitts hin größer wird.

8. Tiegelhalteelement nach einem der Ansprüche 1 bis 7,
bei dem untere Enden der mehreren zerteilten Stücke, die radial angeordnet sind, verbunden sind, während sie einen zylindrischen Raum (35) um die Achsenlinie (L) umgeben,
wobei das Tiegelhaltelement ferner eine Scheibe (37) aufweist, die mit einem zylindrischen Körper (39) von einer oberen Oberfläche von dieser hervorstehend versehen ist,
wobei der zylindrische Körper in den zylindrischen Raum eingepasst ist, der durch die unteren Enden der mehreren zerteilten Stücke umgeben ist.

9. Tiegelhalteelement nach einem der Ansprüche 1 bis 8,
bei dem ein Kohle- oder Graphitfilm auf einer inneren Oberfläche des Tiegelhalteabschnitts an wenigstens einem Abschnitt verteilt ist, bei dem benachbarte zerteilte Graphitstücke in Verbindung gebracht sind.

## Revendications

1. Elément support de creuset (100) comprenant :
une partie supportant un creuset (15) comprenant une série de pièces séparées en graphite (13), divisées longitudinalement, parallèle à un axe longitudinal (L) et disposés de manière radiale ;
un élément externe d'ajustement (19) composé d'un composite C/C, qui a une forme circulaire et ajusté sur une partie de corps de la partie de support du creuset pour lier les pièces séparées en graphite en direction de la circonférence, où toutes les pièces séparées sont formées en coupant un seul block de graphite isotrope dans la même direction de coupe.

2. Elément support de creuset selon la revendication 1, dans lequel l'élément externe d'ajustement est formé d'une structure à mailles (25) comprenant une série de brins (23) de fibres de carbone, tissés en diagonale par rapport à l'axe (L), et une matrice se trouve dans les interstices entre les fibres de carbone de la structure à mailles.

3. Elément support de creuset selon la revendication 2,
dans lequel la structure à mailles comprend :
une série de premiers brins (23A) dirigés dans une première direction inclinée selon un premier angle par rapport à l'axe ;
une série de deuxièmes brins (23B) dirigés dans une deuxième direction inclinée selon un deuxième angle identique au premier angle par rapport à l'axe, la première direction étant opposée à la deuxième direction par rapport à l'axe.

4. Elément support de creuset selon la revendication 2 ou 3, où la structure à mailles (25) comprend en outre, une série de brins longitudinaux (23C) le long de l'axe.

5. Elément support de creuset selon l'une quelconque des revendications 2 à 4, dans lequel la structure à mailles est exempte de brin parallèle à la direction de la circonférence dans un plan perpendiculaire à l'axe.

6. Elément support de creuset selon l'une quelconque des revendications 1 à 5, comprenant en outre, une saillie (27) qui est agencée sur la partie de corps de la partie de support du creuset, et qui régule la chute de l'élément externe d'ajustement.

7. Elément support de creuset selon l'une quelconque des revendications 1 à 5, où l'élément externe d'ajustement et la partie de support du creuset sont ajusté l'un à l'autre par leurs faces biseautées respectives (29, 31), dont le diamètre s'agrandit vers une partie de base de la partie de support de creuset.

8. Elément support de creuset selon l'une quelconque des revendications 1 à 7,
où les extrémités inférieures de la série de pièces séparées disposées de manière radiale sont liées tout en entourant un espace cylindrique autour de l'axe,
l'élément de support de creuset comprenant en outre, une plaque (37) munie d'un corps cylindrique (34) en saillie depuis sa face supérieure,
où le corps cylindrique est ajusté à l'espace cylindrique entouré des extrémités inférieures de la série de pièces séparées.

9. Elément support de creuset selon l'une quelconque des revendications 1 à 8, où une feuille carbonée ou en graphite est étendue sur une surface inférieure de la partie de support du creuset, sur au moins la partie sur laquelle les pièces adjacentes séparées en graphite sont connectées.
